# EUROPÄISCHE PATENTANMELDUNG

(11) **EP 1 638 380 A1**
(43) Veröffentlichungstag der Anmeldung: **22.03.2006**
(21) Anmeldenummer: 04104461.1
(22) Anmeldetag: 15.09.2004
(51) Int. Cl.: H05K 5/00, H05K 5/03, H05K 5/06

(54) **Verfahren zum Verschliessen von Gerätegehäusen mit Foliendeckeln und entsprechend verschlossenes Gerätegehäuse**

(71) Anmelder: Schreiner Group GmbH & Co. KG, 85764 Oberschleissheim (DE)
(72) Erfinder: Horn, Rüdiger, 93455 Sattelbogen (DE); Hartauer, Andrea, 94339 Leiblfing (DE)
(74) Vertreter: Kehl, Günther

(57) **Zusammenfassung**

Das Folienmaterial (21), aus welchem die Foliendeckel (11) entstehen, wird in Rollenform vorgelegt. In regelmäßigen Abständen sind Funktionselemente (22), beispielsweise semipermeable Druckausgleichsmembrane, Transponder etc., in das vorgelegte Folienmaterial (21) integriert. Die bestückten Gehäuseschalen (1) (Bestückung nicht dargestellt) werden mittels Förderbändern bewegt. Das parallel dazu bewegte Folienmaterial (21) wird mittels eines Heißstempels (24) mit dem die Montageöffnung der Geräteschalen (1) umgebenden Rand verschweißt. Anschließend werden die Foliendeckel (11) mittels einer Stanze (25) ausgestanzt. Das Stanzen nach dem Schweißen besitzt den Vorteil, daß keine ausgestanzten Folienteile separat vorliegen. Alternativ können die Foliendeckel (11) mit Funktionselementen (22) zunächst über eine selbstklebende Beschichtung (12) auf einer klebstoffabweisend beschichteten Trägerbahn (26) angeordnet sein und auf die Gehäuseschalen (1) aufgespendet werden.

## Beschreibung

Die vorliegende Erfindung betrifft ein Verfahren zum Verschließen von Montageöffnungen von Gerätegehäusen sowie ein Gerätegehäuse.

Gehäuse von Geräten, insbesondere Geräten, welche elektrische und/oder elektronische Komponenten enthalten, dienen u.a. dazu, das Geräte-Innere vor Umwelteinflüssen zu schützen. Dies gilt in besonderem Maße für die Gehäuse elektronischer Steuergeräte und dergleichen im Automobilbau, welche im Gebrauch oft Nässe, Staub, Steinschlag usw. ausgesetzt sind.

Übliche Gerätegehäuse sind meist im wesentlichen zweiteilig ausgeführt. Dabei ist die Gehäuseteilung häufig unsymmetrisch. Eine Gehäuseschale, welche das tiefere Gehäuseteil darstellt, ist dazu bestimmt, die wesentlichen Gerätekomponenten aufzunehmen. Sie ist nach einer Seite ganz oder teilweise offen, so daß sich eine Montageöffnung ergibt, welche zum Einbau der Gerätekomponenten benötigt wird. Ein meist flacher Gehäusedeckel verschließt die Montageöffnung.

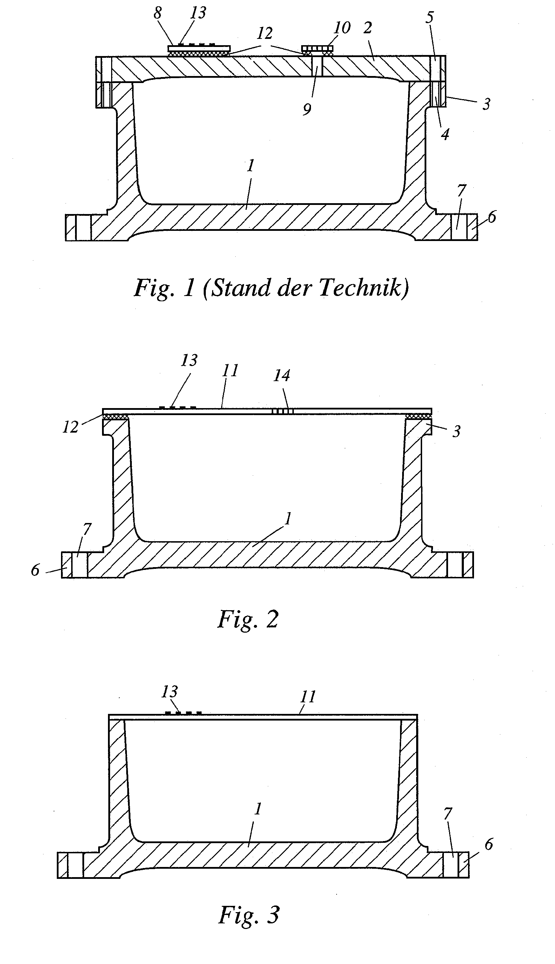

Ein zweiteiliges Gerätegehäuse eines elektronischen Geräts für den industriellen Einsatz nach dem Stand der Technik ist in Fig. 1 als Querschnittzeichnung dargestellt. Die Gehäuseschale 1 ist mit einem flachen Gehäusedeckel 2 durch Verschrauben verschließbar. Hierzu weist die Gehäuseschale 1 einen die Monatgeöffnung umgebenden Flansch 3 mit Gewindebohrungen 4 auf. Fluchtende Bohrungen 5 sind entsprechend im Gehäusedeckel 2 vorgesehen. Sofern erforderlich, kann die Abdichtung beispielsweise über einen O-Ring (nicht dargestellt) erfolgen. Häufig werden, insbesondere bei wartungsfreien Geräten, Gehäusedeckel auch mit Gehäuseschalen verschweißt, beispielsweise durch Reibschweißen.

Über einen weiteren Flansch 6 mit Bohrungen 7 kann das Gehäuse am bestimmungsgemäßen Einsatzort des Geräts mittels Schrauben angebracht werden.

Bei der in Fig. 1 abgebildeten Gehäuseausführung ist auf den Deckel 2 ein bedrucktes Typenschild 8 aufgeklebt. Ferner ist der Deckel 2 mit einer Belüftungsöffnung 9 versehen, welche insbesondere dem Wasserdampfaustausch mit der Umgebung dient, um aufgrund wechselnder Umgebungstemperaturen auftretende Kondensation im Gehäuse-Inneren zu vermeiden. Um das Eintreten von Spritzwasser zu verhindern, ist die Belüftungsöffnung 9 mit einer gaspermeablen Membran 10 überklebt.

Gehäusedeckel liegen üblicherweise vor Verschließen der zugehörigen Gehäuseschalen als Stückgut bzw. Schüttgut vor. Häufig sind sie als Kunststoff-Spritzgußteile ausgeführt, wobei je nach Dichtungsanforderungen und dergleichen bei der Herstellung nach dem Spritzgießen oft auch noch Oberflächen spanabhebend bearbeitet werden müssen.

Das Anbringen der Gehäusedeckel an den zugehörigen Gehäuseschalen ist ein zeitaufwendiger Schritt bei der Gerätefertigung und erfordert mitunter Handarbeit oder, um diese entbehrlich zu machen, eine relativ aufwendige maschinelle Ausstattung.

Vor diesem Hintergrund ist es Aufgabe der vorliegenden Erfindung, ein weniger aufwendiges und gut automatisierbares Verfahren zum Verschließen von Montageöffnungen von Gerätegehäusen bereitzustellen. Ferner ist es Aufgabe der vorliegenden Erfindung, kostengünstiger herstellbare Gerätegehäuse zu schaffen.

Gemäß einem Aspekt der vorliegenden Erfindung wird diese Aufgabe durch ein Verfahren zum Verschließen von Montageöffnungen von Gerätegehäusen mit Foliendeckeln gelöst. Dabei wird ein zusammenhängendes Flachmaterial vorgelegt, aus welchem mehrere Foliendeckel gebildet und am jeweiligen Gerätegehäuse über dessen Montageöffnung angebracht werden. Das Flachmaterial kann vorteilhafterweise in Form, auch gerollter, Bahnen oder Bogen vorgelegt werden. Gestapeltes bzw. gerolltes Flachmaterial läßt sich leichter handhaben als eine hohe Anzahl einzelner, vorgeformter Deckel, und benötigt bei der Lagerung auch weniger Platz. Die Verwendung folienartigen Flachmaterials führt zudem gegenüber herkömmlichen Spritzgußteilen in der Regel zu einer erheblichen Materialeinsparung.

Unter einem Foliendeckel wird im Zusammenhang mit vorliegender Erfindung ein überwiegend aus Folienmaterial bestehender Deckel verstanden, d.h. ein Deckel aus einem mittels eines Folienprozesses hergestellten Materials oder Materialverbunds mit einer Materialdicke von in der Regel unter 1 mm, typischerweise zwischen 100 und 500 *µ*m. Vorteilhaft können je nach Anwendungsfall ein-oder mehrlagige Folien aus verschiedensten Kunststoffen, wie beispielsweise PE, PP, PTFE, PVC usf., sein. In bestimmten Fällen können auch metallische Folienlagen, beispielsweise aus Aluminium, vorteilhaft Verwenung finden, etwa wenn eine elektromagnetische Abschirmwirkung erwünscht ist. Zur Erhöhung der mechanischen Stabilität können auch Karton- oder Gewebelagen vorgesehen sein. Auch ganz- oder teilweise transparente Ausführungen sind möglich.

Vorteilhafterweise erfolgt das Bilden der Foliendeckel und das Anbringen am jeweiligen Gerätegehäuse in einem fortlaufenden Prozeß. Unter einem fortlaufenden Prozeß wird dabei verstanden, daß das Ausbilden der Foliendeckel aus dem Flachmaterial und das Anbringen am jeweils zugehörigen Gehäuse gleichzeitig oder unmittelbar nacheinander, d.h. vorzusweise in einer gemeinsamen Fertigungsstraße, vonstatten geht, und nicht etwa vorgefertigte Deckel zwischengelagert werden.

Das Anbringen der Foliendeckel kann vorteilhafterweise durch Schweißen, beispielsweise Ultraschallschweißen oder mittels eines Heißstempels, oder durch Kleben erfolgen.

Zum Kleben dienen vorzugsweise haftklebende Beschichtungen, je nach Anwendungsfall kann jedoch auch der Auftrag von Klebstoff unmittelbar vor dem Verkleben vorteilhaft sein. Grundsätzlich eignet sich eine große Bandbreite an üblichen Klebstoffen, woraus in Abhängigkeit des konkreten Anwendungsfalls auszwählen ist. Neben üblichen Haftklebstoffen können hitzeaktivierbare Klebstoffe (sogenannte Hotmelts) und mittels UV-Licht oder Feuchteexposition aushärtende Klebstoffe vorteilhaft sein. Sollen selbstklebende Beschichtungen zum Einsatz kommen, so kann das Flachmaterial vorteilhafterweise einen klebstoffabweisend beschichteten Träger aufweisen, auf welchem die nach Verspenden als Foliendeckel dienenden Folienstücke angeordnet sind.

Gemäß einer weiteren vorteilhaften Ausführungsform der Erfindung umfaßt das Bilden der Foliendeckel das Durchtrennen des Flachmaterials entlang einer vorgegebenen Kontur. Die Deckelkontur kann dabei beispielsweise durch Stanzen oder lokales Aufschmelzen erfolgen. In letzterem Fall lassen sich das Bilden der Deckelkontur und das Verschweißen mit dem Gehäuse auch in einem Arbeitsgang bewerkstelligen.

Gemäß einer vorteilhaften Weiterbildung der Erfindung kann das Bilden der Foliendeckel einen Verformungsschritt umfassen. Die Verformung kann dabei beispielsweise thermoplastisch oder durch Kaltvakuum-Verformen erfolgen.

Gemäß einer besonders bevorzugten Weiterbildung der vorliegenden Erfindung wird ein Flachmaterial mit Funktionselementen vorgelegt, und die Foliendeckel werden so aus dem Flachmaterial gebildet, daß die Funktionselemente regelmäßig auf die Foliendeckel verteilt sind. Unter Funktionselementen werden dabei verschiedenste funktionale Komponenten verstanden, beispielsweise Druckausgleichsmembranen, Transponderanordnungen, Sensoren, Farbindikatoren (beispielsweise reagierend auf Feuchte-, Temperatur- oder pH-Wert-Änderungen), Aufhängelaschen, die Fälschung erschwerdene Sicherheitsmerkmale (beispielsweise Hologramme, Mikroschrift und dgl.), abnehmbare Abschnitte, Fenster usw. Derartige Komponenten mußten bisher in zusätzlichen Arbeitsschritten angebracht werden, beispielsweise in Form von Etiketten. Erfindungsgemäß ist es nunmehr möglich, Funktionselemente vorab mit bekannten Prozessen in das folienförmige Deckelausgangsmaterial zu integrieren. Die separate Beschaffung, Lagerung und Anbringung von Transponderetiketten (beispielsweise für logistische Überwachungsaufgaben), Membranabdeckungen und dergleichen kann somit entfallen.

Gemäß einer weiteren bevorzugten Ausführungsform ist mindestens ein Beschriftungsvorgang vorgesehen. Unter Beschriftung wird dabei das Versehen mit alphanumerischen Zeichen, Symbolen oder auch sonstiger Bild- oder Code-Information (beispielsweise in Form von Barcodes) verstanden. Die Beschriftung kann dabei vorteilhafterweise durch Bedrucken, beispielsweise mittels Thermotransferdruck, oder mittels Laserbeschriftung erfolgen. Für Laserbeschriftbarkeit ist ein Flachmaterial zu verwenden, welches eine lasermanipulierbare Schicht aufweist. Dabei kann es sich um laserablatierbare (beispielsweise in Form einer Metallisierung) oder photosensible Schichten handeln.

Durch die Beschriftung können die Folindeckel auch die Funktion eines Typenschilds oder dgl. übernehmen. Typenschilder mußten bisher in zusätzlichen Arbeitsschritten angebracht werden, beispielsweise in Form von Etiketten. Erfindungsgemäß ist es nunmehr möglich, Typenschildinformation mit bekannten Prozessen vorab in das folienförmige Deckelausgangsmaterial zu integrieren. Die separate Beschaffung, Lagerung und Anbringung von Typenschildern kann somit entfallen.

Vorteilhafterweise kann das Verfahren auch einen oder mehrere Schritte zum Einbringen einer Perforation aufweisen, um ein definiertes Öffnen zu ermöglichen. Bei ausreichend klein gewählter Lochgröße, beispielsweise im Bereich von 100 Mikrometern, evtl. bis 300 Mikrometern oder darüber, kann je nach Anforderungen noch ein ausreichender Spritzwasser- bzw. Staubschutz gewährleistet sein. Entsprechend kleine Perforationsöffnungen lassen sich beispielsweise mittels Laserperforation erzeugen.

Gemäß einem weiteren Aspekt der vorliegenden Erfindung wird die zugrundeliegende Aufgabe durch ein Gerätegehäuse gelöst, dessen Montageöffnung mit einem Foliendeckel verschlossen ist. Ein derartiges Gerätegehäuse ist mit dem erfinderischen Verfahren herstellbar. Über die Materialwahl für den Foliendeckel gilt entsprechend das oben gesagte. Die mit dem Foliendeckel verschlossene Gehäuseschale kann wie herkömmliche Gehäuseschalen aus allen gängigen Materialien, beispielsweise Kunststoff, Metall, Keramik und Verbundmaterialien auf herkömmliche Weise gefertigt sein.

Der Foliendeckel erstreckt sich vorzugsweise über den Großteil der Gehäuseseite, auf welcher sich die Montageöffnung befindet. Besonders bevorzugt erstreckt sich der Foliendeckel über die gesamte Gehäuseseite, auf welcher sich die Montageöffnung befindet. Eine zusätzliche Wandung ist somit auf dieser Seite entbehrlich, wodurch eine beträchtliche Materialeinsparung möglich ist. Ferner kann die Montageöffnung so größtmöglich ausgeführt werden, was den Einbau der Gerätekomponenten erleichtert.

Je nach Anwendungsfall kann es besonders vorteilhaft sein, wenn sich der Foliendeckel zumindest teilweise über die Geäuseseite, auf welcher sich die Montageöffnung befindet, hinaus auf eine weitere Gehäuseseite erstreckt. Bei einem mit dem Gehäuse verklebten Foliendeckel ergibt sich so eine größere Stabilität gegen Ablösen.
Der Foliendeckel kann, wie im Zusammenhang mit dem erfindungsgemäßen Verfahren erläutert, vorteilhafterweise aufgeschweißt oder aufgeklebt sein.

Meist wird eine ebene Ausbildung des Foliendeckels zumindest auf der Geäuseseite, auf welcher sich die Montageöffnung befindet, vorteilhaft sein. Jedoch sind auch dreidimensionale, beispielsweise durch Tiefziehen erhaltene, Formgebungen bei entsprechender Folienstärke möglich und können je nach Awendungsfall eine günstige Lösung darstellen.

Gemäß einer vorteilhaften Weiterbildung der Erfindung weist der Foliendeckel ein oder mehrere Funktionselemente der oben geschilderten Art auf.

Gemäß einer besonders bevorzugten Ausführungsform weist der Foliendeckel eine Beschriftung auf, welche, wie im Zusammenhang mit dem erfindungsgemäßen Verfahren erläutert, vorteilhafterweise als Aufdruck oder Laserbeschriftung ausgeführt sein kann.

Wie bereits im Zusammenhang mit dem erfindungsgemäßen Verfahren erläutert, kann ein erfindungsgemäßer Foliendeckel auch eine Perforation aufweisen, um ein definiertes Öffnen zu ermöglichen. Wie erläutert kann bei ausreichend klein gewählter Lochgröße, beispielsweise im Bereich von 100 Mikrometern, evtl. bis 300 Mikrometern oder darüber, kann je nach Anforderungen noch ein ausreichender Spritzwasser- bzw. Staubschutz gewährleistet sein. Ferner ist es möglich, die Perforation in dem Bereich anzuordnen, wo der Foliendeckel auf dem Gehäuserand aufliegt. Hierdurch werden Spritzwasser- bzw. Staubschutz kaum beeinträchtigt. Außerdem kann innen- und oder außenseitig eine Folienlasche vorgesehen sein, welche die Perforation überdeckt und somit vor eindringenden Fremdstoffen schützt. Eine derartige Lasche kann aufgeklebt, aufgeschweißt oder anderweitig befestigt sein. Denkbar sind auch wiederverschließbare Lösungen mit selbstklebenden Laschen. Für eine derartige Wiederverschließbarkeit kann die Lasche oder ein Folienbereich, auf welchem diese aufliegt, auch eine Haftklebstoffbeschichtung aufweisen, welche zunächst mit einem Abziehmaterial abgedeckt ist, welches vor dem Wiederverschließen abgezogen wird. Wird eine derartige Verklebung zum Zwecke des Wiedervecschließens Innenseitig vorgesehen, so können die Klebeflächen im Einsatz des Geräts frei von Verunreinigungen bleiben.

Grundsätzlich kann jede im Rahmen der vorliegenden Anmeldung beschriebene bzw. angedeutete Variante der Erfindung besonders vorteilhaft sein, je nach wirtschaftlichen und technischen Bedingungen im Einzelfall. Soweit nichts gegenteiliges dargelegt ist, bzw. soweit grundsätzlich technisch realisierbar, sind einzelne Merkmale der beschriebenen Ausführungsformen austauschbar oder miteinander kombinierbar.

Nachfolgend werden anhand der zugehörigen Zeichnungen Beispiele bevorzugter Ausführungsformen der vorliegenden Erfindung näher erläutert. Die Zeichnungen sind dabei rein schematische und nicht maßstäbliche Darstellungen, insbesondere sind bei Schnittdarstellungen Folienschichtdicken aus Anschaulichkeitsgründen stark vergrößert. Einander entsprechende Elemente sind in den einzelnen Figuren jeweils soweit sinnvoll mit denselben Bezugszeichen versehen. Die Bestückung der Gehäuse mit elektrischen bzw. elektronischen Gerätekomponenten ist nicht dargestellt.
- Fig. 1: zeigt ein Gerätegehäuse nach dem Stand der Technik, wie oben erläutert.
- Fig. 2: zeigt in Schnittdarstellung ein erfindungsgemäßes Gerätegehäuse mit Foliendeckel, welcher einen Aufdruck und einen als Druckausgleichsmembran ausgebildetem Bereich aufweist.
- Fig. 3: zeigt ein ähnlich wie in Fig. 2 ausgeführtes Gerätegehäuse, wobei jedoch der Foliendeckel mit der Gehäuseschale verschweißt ist.
- Fig. 4: zeigt ein weiteres erfindungsgemäßes Gerätegehäuse in Schnittdarstellung, wobei der Foliendeckel eine Belüftungsöffnung mit aufgeklebter Membran sowie eine Transponderanordnung aufweist.
- Fig. 5: zeigt eine weiteres erfindungsgemäßes Gerätegehäuse mit laserbschriftetem Foliendeckel.
- Fig. 6: illustriert anhand eines Ausschnitts einer Fertigungsstraße eine Ausführungsform des erfindungsgemäßen Verfahrens, bei welcher die Bereiche der Foliendeckel zuerst mit Gehäuseschalen verschweißt und anschließend ausgestanzt werden.
- Fig. 7: illustriert anhand eines Ausschnitts einer Fertigungsstraße eine weitere Ausführungsform des erfindungsgemäßen Verfahrens, bei welcher die Foliendeckel bedruckt und anschließend von einer Trägerbahn aus auf Gehäuseschalen verspendet werden.

Das in Fig. 2 dargestellte Gerätegehäuse weist eine Gehäuseschale auf, welche weitgehend ausgeführt ist wie nach dem oben beschriebenen Stand der Technik. Der die Montageöffnung umgebende Flansch 3 dient lediglich der Vergrößerung der Fläche, auf welcher der Foliendeckel 11 mit der Gehäuseschale 1 verklebt ist. Je nach Klebstoffbeschichtung 12, Gehäusewandstärke und zu erwartender mechanischer Beanspruchung kann der Flansch 3 mitunter auch entfallen. Ferner kann die Stabilität der Klebeverbindung erhöht werden, indem der Foliendeckel 11 mit einer seitlichen Fläche der Gehäuseschale verklebt wird, d.h. um die äußer Kante der die Montageöffnung enthaltenden Seite herumgezogen wird. Der Foliendeckel 11 weist einen Aufdruck 13 auf. Ferner ist ein Bereich 14 des Foliendeckels als gaspermeable Membran ausgebildet, indem feine Löcher vorgesehen sind. Alternativ kann auch eine der Belüftung dienende Öffnung im Foliendeckel 11 vorgesehen sein, welche mit einer mit dem übrigen Foliendeckel 11 verschweißten oder verklebten gaspermeable Membran abgedeckt ist. Auch eine Ausbildung des gesamten Foliendeckels 11 als gaspermeable Membran ist möglich. Je nachdem, ob mit kondensation im Gehäuse-Inneren zu rechnen ist, kann auf eine Belüftungseinrichtung auch verzichtet werden.

Fig. 3 zeigt eine ähnlich Fig. 2 gestaltetes Gerätegehäuse, wobei jedoch auf einen gaspermeablen Membranbereich verzichtet wurde, sowie Gehäuseschale 1 und Foliendeckel 11 miteinander verschweißt sind.

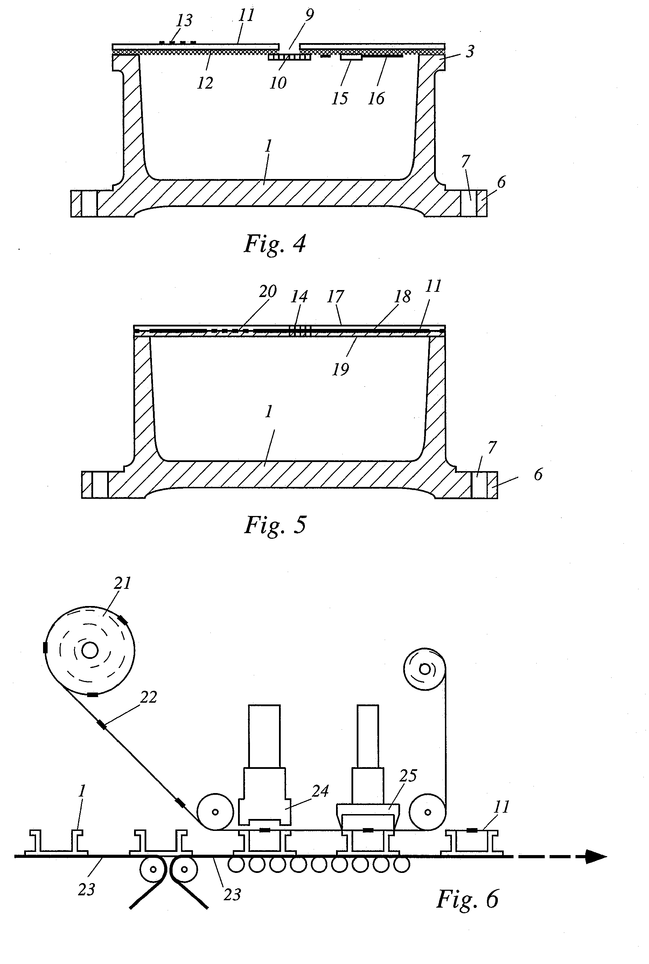

Auch die in Fig. 4 dargestellte Ausführungsform ist ähnlich der Variante aus Fig. 2 gestaltet. Im Unterschied zu Fig. 2 erstreckt sich jedoch die Klebstoffbeschichtung 12 über fast die gesamte Unterseite des Foliendeckels 11. Über die Klebstoffbeschichtung 12 mit dem restlichen Foliendeckel 11 verbunden sind eine Transponderanordnung sowie eine hydrophobe oder hydrophobisierte, gaspermeable Membran 10, welche die Belüftungsöffnung 9 abdeckt und als Spritzwasserschutz dient. Die Transponderanordnung weist einen Chip 15 und eine Antenne 16 auf und dient der automatisierten Identifikation des Gerätegehäuses im Rahmen logistischer Abläufe.

In Fig. 5 ist ein Gerätegehäuse dargestellt, dessen Foliendeckel 11 mehrfach mittels Lasereinwirkung bearbeitet ist. Der Foliendeckel 11 weist eine transparente Schutzschicht 17, eine opake laserablatierbare Schicht 18 und eine eingefärbte Kontrastschicht 19 auf. Lokale Bereiche 20 der laserablatierbaren Schicht 18 sind mittels Lasereinwirkung entfernt, so daß dort die Kontrastschicht 19 durch die Schutzschicht 17 hindurch sichtbar ist. Die ablatierten Bereiche 20 weisen die Form von Zeichenkonturen auf, so daß sich eine Beschriftung ergibt. Auch die Verschweißung des Foliendeckels 11 mit der Gehäuseschale 1 ist durch Lasereinwirkung, jedoch mit höherem Energieeintrag erzeugt. Die mikroskopischen Löcher des gaspermeablen Bereichs 14 sind ebenfalls durch hochenergetische Lasereinwirkung erzeugt. Ferner kann auch die Kontur des Foliendeckels 11 mittels eines Laserstrahls ausgeschnitten sein.

Wesentliche Schritte eines erfindungsgemäß gestalteten Verfahrens lassen sich anhand Fig. 6 verdeutlichen. Das Folienmaterial 21, aus welchem die Foliendeckel 11 entstehen, wird in Rollenform vorgelegt. In regelmäßigen Abständen sind Funktionselemente 22 in das vorgelegte Folienmaterial 21 integriert. Die bestückten Gehäuseschalen 1 (Bestückung nicht dargestellt) werden mittels Förderbändern bewegt. Das parallel dazu bewegte Folienmaterial 21 wird mittels eines Heißstempels 24 mit dem die Montageöffnung der Geräteschalen 1 umgebenden Rand verschweißt.

Anschließend werden die Foliendeckel 11 mittels einer Stanze 25 ausgestanzt. Das Stanzen nach dem Schweißen besitzt den Vorteil, daß keine ausgestanzten Folienteile separat vorliegen.

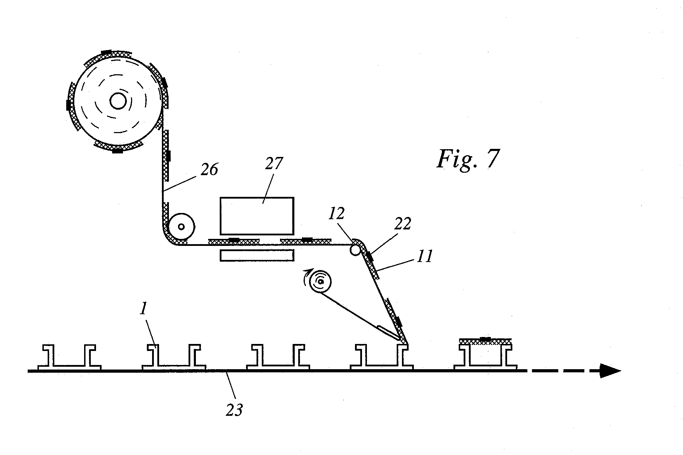

Wesentliche Schritte eines weiteren erfindungsgemäß gestalteten Verfahrens lassen sich anhand Fig. 7 verdeutlichen. Hier sind die Foliendeckel 11 mit Funktionselementen 22 zunächst über die selbstklebende Beschichtung 12 auf einer klebstoffabweisend beschichteten Trägerbahn 26 angeordnet. Die Trägerbahn 25 mit den Foliendeckeln:11 wird durch ein Druckwerk 27 geführt, welches die Foliendeckel 11 mit einem Aufdruck versieht. Nach der Bedruckung werden die Foliendeckel 11 auf die Gehäuseschalen 1 aufgespendet.

## Patentansprüche

1. Verfahren zum Verschließen von Montageöffnungen von Gerätegehäusen (2) mit Foliendeckeln (11), wobei ein zusammenhängendes Flachmaterial (21) vorgelegt wird, aus welchem mehrere Foliendeckel (11) gebildet und am jeweiligen Gerätegehäuse (2) über dessen Montageöffnung angebracht werden.

2. Verfahren gemäß Anspruch 1, wobei das Bilden der Foliendeckel (11) und das Anbringen am jeweiligen Gerätegehäuse (2) in einem fortlaufenden Prozeß erfolgt

3. Verfahren gemäß einem der vorangehenden Ansprüche, wobei das Flachmaterial (21) in Rollenform vorgelegt wird.

4. Verfahren gemäß einerm der Ansprüche 1-2, wobei das Flachmaterial (21) in Bogenform vorgelegt wird.

5. Verfahren gemäß einem der vorangehenden Ansprüche, wobei das Anbringen der Foliendeckel (11) durch Schweißen- erfolgt.

6. Verfahren gemäß einem der Ansprüche 1-4, wobei das Anbringen der Foleindeckel (11) durch Kleben erfolgt.

7. Verfahren gemäß Anspruch 6, wobei das Flachmaterial einen klebstoffabweisend beschichteten Träger (26) aufweist, und das Bilden der Foliendeckel (11) das Ablösen selbstklebender Folienstücke vom Träger (26) umfaßt.

8. Verfahren gemäß einem der Ansprüche 1-6, wobei das Bilden der Foliendeckel (11) das Durchtrennen des Flachmaterials (21) entlang einer vorgegebenen Kontur umfaßt.

9. Verfahren gemäß einem der vorangehenden Ansprüche, wobei das Bilden der Foliendeckel (11) einen Verformungsschritt umfaßt.

10. Verfahren gemäß einem der vorangehenden Ansprüche, wobei ein Flachmaterial (21) mit Funktionselementen (22) vorgelegt wird; und die Foliendeckel (11) so aus dem Flachmaterial (21) gebildet werden, daß die Funktionselemente (22) regelmäßig auf die Foliendeckel 811) verteilt sind.

11. Verfahren gemäß einem der vorangehenden Ansprüche, wobei mindestens ein Beschriftungsvorgang vorgesehen ist.

12. Verfahren gemäß Anspruch 11, wobei mindestens ein Beschriftungsvorgang eine Laserbeschriftung ist.

13. Verfahren gemäß einem der Ansprüche 11-12, wobei mindestens ein Beschriftungsvorgang ein Bedrucken ist.

14. Verfahren gemäß einem der vorangehenden Ansprüche, wobei mindestens ein Perforationsschritt vorgesehen ist.

15. Verfahren gemäß Anspruch 14, wobei der mindestens eine Perforationsschritt eine Laserperforation beinhaltet.

16. Gerätegehäuse (2), aufweisend eine Montageöffnung, welche mit einem Foliendeckel (11) verschlossen ist.

17. Gerätegehäuse (2) gemäß Anspruch 16, wobei sich der Foliendeckel (11) über den Großteil der Gehäuseseite erstreckt, auf welcher sich die Montageöffnung befindet.

18. Gerätegehäuse (2) gemäß Anspruch 17, wobei sich der Foliendeckel (11) über die gesamte Gehäuseseite erstreckt, auf welcher sich die Montageöffnung befindet.

19. Gerätegehäuse (2) gemäß einem der Ansprüche 16-18, wobei sich der Foliendeckel (11) zumindest teilweise über die Geäuseseite, auf welcher sich die Montageöffnung befindet, hinaus auf eine weitere Gehäuseseite erstreckt.

20. Gerätegehäuse (2) gemäß einem der Ansprüche 16-19, wobei der Foliendeckel (11) aufgeschweißt ist.

21. Gerätegehäuse (2) gemäß einem der Ansprüche 16-19, wobei der Foliendeckel (11) aufgeklebt ist.

22. Gerätegehäuse (2) gemäß einem der Ansprüche 16-21, wobei der Foliendeckel (11) zumindest auf der Geäuseseite, auf welcher sich die Montageöffnung befindet, eben ausgebildet ist.

23. Gerätegehäuse (2) gemäß einem der Ansprüche 16-21, wobei der Foliendeckel (11) auf der Geäuseseite, auf welcher sich die Montageöffnung befindet, eine dreidimensionale Formgebung aufweist

24. Gerätegehäuse (2) gemäß einem der Ansprüche 16-23, wobei der Foliendeckel (11) mindestens ein Funktionselement (22) aufweist.

25. Gerätegehäuse (2) gemäß Anspruch 24, wobei es sich bei mindestens einem Funktionselement um eines der folgenden handelt:
- eine gaspermeable Membran (10, 14),
- eine Transponder-Anordnung (15, 16),
- einen Sensor,
- ein Leuchtelement,
- einen abtrennbaren Abschnitt,
- ein fälschungssicheres Echtheitsmerkmal,
- einen Aufhänger.

26. Gerätegehäuse (2) gemäß einem der Ansprüche 16-25, wobei der Foliendeckel (11) eine Beschriftung (13, 20) aufweist.

27. Gerätegehäuse (2) gemäß Anspruch 26, wobei es sich bei zumindest einem Teil der Beschriftung (13, 20) um eine Laserbeschriftung (20) handelt.

28. Gerätegehäuse (2) gemäß einem der Ansprüche 26-27, wobei es sich bei zumindest einem Teil der Beschriftung (13, 20) um einen Aufdruck (13) handelt.

29. Gerätegehäuse (2) gemäß einem der Ansprüche 16-28, wobei der Foliendeckel (11) eine Perforation aufweist.

30. Gerätegehäuse (2) gemäß Anspruch 29, wobei es sich bei der Perforation um eine Laserperforation handelt.

31. Gerätegehäuse (2) gemäß einem der Ansprüche 29-30, wobei mindestens eine die Perforation innen und/oder außen abdeckende Lasche vorgesehen ist.
